# NEUE EUROPÄISCHE PATENTSCHRIFT

(11) **EP 2 286 254 B2**
(45) Veröffentlichungstag und Bekanntmachung des Hinweises auf die Entscheidung über den Einspruch: **02.12.2015**
(45) Hinweis auf die Patenterteilung: 24.08.2011
(21) Anmeldenummer: 09761392.1
(22) Anmeldetag: 27.05.2009
(51) Int. Cl.: G01R 31/12, G01R 31/06

(54) **PRÜFANORDNUNG ZUR WECHSELSPANNUNGSPRÜFUNG VON ELEKTRISCHEN HOCHSPANNUNGSKOMPONENTEN**
TEST ASSEMBLY FOR AC TESTING OF ELECTRIC HIGH VOLTAGE COMPONENTS
DISPOSITIF D'ESSAI POUR DES COMPOSANTS ÉLECTRIQUES À HAUTE TENSION PAR COURANT ALTERNATIF

(30) Priorität: 12.06.2008 EP 08010691
(43) Veröffentlichungstag der Anmeldung: 23.02.2011
(73) Patentinhaber: ABB Technology AG, 8050 Zürich (CH)
(72) Erfinder: WERLE, Peter, 29664 Walsrode (DE); SZCZECHOWSKI, Janusz, 04229 Leipzig (DE); STEIGER, Matthias, 06779 Schierau (DE)
(74) Vertreter: Kock, Ina
(86) Internationale Anmeldenummer: PCT/EP2009/003756
(87) Internationale Veröffentlichungsnummer: WO 2009/149829

(56) Entgegenhaltungen:
- US-A- 2 551 841
- US-B1- 6 586 697
- WINTER A ET AL: "A mobile transformer test system based on a stativ frequency converter" INTERNET CITATION, 4. September 2007 (2007-09-04), XP002500564
- SCHUFFT W ET AL: "Frequency-tuned resonant test systems for on-site testing and diagnostics of extruded cables" HIGH VOLTAGE ENGINEERING, 1999. ELEVENTH INTERNATIONAL SYMPOSIUM ON (C ONF. PUBL. NO. 467) LONDON, UK 23-27 AUG. 1999, LONDON, UK,IEE, UK, Bd. 5, 23. August 1999 (1999-08-23), Seiten 335-339, XP006501811 ISBN: 978-0-85296-719-5
- WINTER A ET AL: "A New Generation of On-Site Test Systems for Power Transformers" 2008 IEEE INTERNATIONAL SYMPOSIUM ON ELECTRICAL INSULATION; 9-12 JUNE 2008; VANCOUVER, BC, CANADA, IEEE, 10. Juni 2008 (2008-06-10), Seiten 478-482, XP007906016 ISBN: 978-1-4244-2092-6
- SCHIERIG S ET AL: "HV AC generation based on resonant circuits with variable frequency for testing of electrical power equipment on site" CONDITION MONITORING AND DIAGNOSIS, 2008. CMD 2008. INTERNATIONAL CONFERENCE ON, IEEE, PISCATAWAY, NJ, USA, 21. April 2008 (2008-04-21), Seiten 684-691, XP031292593 ISBN: 978-1-4244-1621-9
- GRUN T ET AL: "Equipment for on-site testing of HV insulation" HIGH VOLTAGE ENGINEERING, 1999. ELEVENTH INTERNATIONAL SYMPOSIUM ON (C ONF. PUBL. NO. 467) LONDON, UK 23-27 AUG. 1999, LONDON, UK,IEE, UK, Bd. 5, 23. August 1999 (1999-08-23), Seiten 240-243, XP006501801 ISBN: 978-0-85296-719-5
- LOPEZ-ROLDAN ET AL: "Mobile Substations: Application, Engineering and Structural Dynamics" PES TD 2005/2006 MAY 21-24, 2006, PISCATAWAY, NJ, USA,IEEE, 1. Januar 2006 (2006-01-01), Seiten 951-956, XP031101946 ISBN: 978-0-7803-9194-9
- JOSE LOPEZ-ROLDAN ET AL: "How to Achieve a Rapid Deployment of Mobile Substations and to Guarantee Its Integrity During Transport" IEEE TRANSACTIONS ON POWER DELIVERY, IEEE SERVICE CENTER, NEW YORK, NY, US, Bd. 23, Nr. 1, 1. Januar 2008 (2008-01-01), Seiten 196-202, XP011197613 ISSN: 0885-8977
- 04 Juli 2008, CUVILLIER VERLAG, GÖTTINGEN, ISBN 9783867276368 vol. MARTIN, FLORIAN: 'Hochspannungsprüfsystem auf BasiS LEISTUNGSELEKTRONISCHER FREQUENZKONVERTER', Seiten 141 - 142
- Bild Archiv: VEB VEM transformatoren und Rontgenwerk Dresden. Dez. 1965
- Highvolt Datenblatt Dresden, Data Sheet no 1.22/2. Tunable Modular Reactors of High Power, Types DERI...M,G

## Beschreibung

Die Erfindung betrifft eine Prüfanordnung zur Wechselspannungsprüfung von elektrischen Hochspannungskomponenten mit wenigstens einem Wechselrichter, mit wenigstens einem Prüftransformator, mit wenigstens einer Hochspannungsdrossel und mit wenigstens einer weiteren Hochspannungskomponente als Prüfkomponenten, wobei wenigstens die genannten Prüfkomponenten in einem gemeinsamen quaderförmigen Behälter angeordnet sind.

Es ist allgemein bekannt, dass Hochspannungskomponenten, wie beispielsweise Leistungstransformatoren, einem Alterungsprozess unterworfen sind, welcher insbesondere die elektrische Isolation betrifft. Von daher sind zur Sicherstellung eines fehlerfreien Betriebes eines elektrischen Energieverteilungsnetzes mit derartigen Komponenten in bestimmten Zeitintervallen Prüfungen, insbesondere der Leistungstransformatoren, sinnvoll. Eine derartige Prüfung ist auch nach einer Reparatur oder Wartung eines Transformators sinnvoll bzw. erforderlich. Derartige Prüfungen geben Aufschluss über den Zustand beispielsweise der Isolation und ermöglichen auch die Detektion anderer Fehler der betreffenden Komponente.

Komponenten wie Leistungstransformatoren weisen ein sehr hohes Gewicht auf, je nach elektrischer Nennleistung auch über 100t. Ein Transport eines derartigen innerhalb eines elektrischen Energieverteilungsnetzes eingebauten Leistungstransformators in ein fest installiertes Prüffeld, in welchem dieser mittels einer Wechselspannungsprüfung geprüft werden könnte, ist aufgrund des hohen Transportaufwandes für den jeweiligen Leistungstransformator zumeist nicht sinnvoll. Zudem ist in den seltensten Fällen genügend Redundanz in einem Energieverteilungsnetz vorhanden, dass ein Leistungstransformator längerfristig ohne Beeinträchtigung des Netzbetriebes ausgebaut werden könnte.

Aus diesem Grund erfolgen derartige Wechselspannungsprüfungen von Leistungstransformatoren zumeist vor Ort. Die Prüfanordnung mit Wechselspannungsgenerator sowie weiteren für die Prüfung benötigten Hochspannungskomponenten wie Hochspannungsdrossel, Spannungsteiler, Messvorrichtungen aber auch mit Niederspannungskomponenten wie Auswertevorrichtungen wird in mehreren Baugruppen zu dem Ort, an dem sich der zu prüfende Leistungstransformator befindet, transportiert und dort zu einer Prüfanordnung montiert. Insbesondere die Hochspannungsdrossel, welche für eine Resonanzprüfung zur Bildung eines Resonanzschwingkreises mit dem Prüfling benötigt wird, kann mit einer Höhe von beispielsweise 2,5m und einem Innendurchmesser von beispielsweise 1m eine Prüfkomponente von beachtlicher Größe darstellen. Auch der Spannungsteiler, welcher zur Messung der hohen Spannungen von beispielsweise bis zu mehreren 100kV im Resonanzschwingkreis benötigt wird, ist eine Hochspannungskomponente mit ähnlicher Höhe.

Bei der Durchführung einer Wechselspannungsprüfung ist darauf zu achten, dass die Hochspannungskomponenten der Prüfanordnung aufgrund der hohen auftretenden Spannungen einen genügend großen Abstand zueinander und zu angrenzendem Erdpotential aufweisen.

So ist aus der Veröffentlichung "A mobile transformer test system based on a static frequency converter" (Winter et al., 15th International Symposium on High Voltage Engineering, University of Lljubljana, Elektroinstitut Milan Vidmar, Lljubljana, Slovenia, August 27-31, 2007) bekannt, statische Prüfsysteme für die Wechselspannungsprüfung von Transformatoren auch mobil auszuführen. In dem Dokument US 6586671 ist eine mittels Tieflader transportierbare Schaltanordnung bekannt welche auch transportierbare zugehörige elektrische Gerätschaften umfasst.

Nachteilig ist, dass die Montage der verschiedenen Baugruppen vor Ort mit einem erheblichen Zeitaufwand verbunden ist. Insbesondere die Positionierung und Montage einer Hochspannungsdrossel oder eines Spannungsteilers sind sehr zeitaufwändig.

Ausgehend von diesem Stand der Technik ist es Aufgabe der Erfindung, eine Prüfanordnung anzugeben, welche einen verringerten Platzbedarf aufweist und einfach transportierbar ist.

Diese Aufgabe wird gelöst durch eine Prüfanordnung mit den im Anspruch 1 angegebenen Merkmalen. Diese ist unter anderem dadurch gekennzeichnet, dass die wenigstens eine Hochspannungsdrossel mittels einer Bewegungsvorrichtung durch wenigstens eine Öffnung an einer Begrenzungsfläche des Behälters zumindest teilweise aus diesem bewegbar ist und dass die wenigstens eine weitere Hochspannungskomponente innerhalb des quaderförmigen Behälters von einer Transportposition in eine Arbeitsposition bewegbar ist.

Unter Hochspannungskomponenten sind diejenigen elektrischen Komponenten zu verstehen, welch in der Prüfanordnung elektrisch miteinander verschaltbar sind. Dies sind beispielsweise Elemente eines Resonanzschwingkreises wie Induktivität, Kapazität oder Widerstand, aber auch jegliche Messvorrichtungen wie Strom- und Spannungswandlern oder auch Spannungsableiter, welche gegebenenfalls zu Schutzzwecken notwendig sind. Erfindungsgemäß ist die Prüfanordnung nicht zwangsläufig nur als einphasiger Resonanzschwingkreis verschaltbar sondern auch als dreiphasiger Prüfkreis zur phasenweisen Prüfung eines Prüflings wie einem Leistungstransformator, dies allerdings nicht als Resonanzschwingkreise und daher mit einer geringeren Spannung, beispielsweise 110kV. In diesem Fall wären die Hochspannungsprüfkomponenten jeweils dreifach vorzuhalten, insbesondere auch der Wechselrichter, der Prüftransformator, welcher die vom Wechselrichter erzeugte Spannung auf ein höheres Spannungsniveau überträgt, und die Spannungswandler.

Die Isolationsabstände zwischen der Hochspannungsdrossel und weiteren angrenzenden Hochspannungskomponenten beziehungsweise angrenzendem Erdpotential sind durch die Bewegung der wenigstens einen weiteren Hochspannungskomponente von einer Transportposition in eine Arbeitsposition vorteilhaft steigerbar. Somit ist bei einer ersten Anordnungsvariante, einer Transportposition, der Hochspannungsdrossel innerhalb des Behälters eine besonders platzsparende Anordnung gegeben, welche den Transport der Prüfanordnung vereinfacht. Bei einer weiteren Anordnungsvariante der Hochspannungsdrossel außerhalb des Behälters, in einer Arbeitsposition, sind die Isolationsabstände erhöht, was den Betrieb der Anordnung ermöglicht oder zumindest isolationstechnisch sicherer gestaltet. Der Wechsel zwischen den Anordnungsvarianten erfolgt durch die Bewegungsvorrichtung, beispielsweise einer teleskopähnlichen Schiene, in besonders einfacher Form.

Nach Herausbewegen der Hochspannungsdrossel aus dem Behälter ist ein Freiraum innerhalb des Behälters entstanden. Dieser wird erfindungsgemäß durch eine Neuanordnung ausgewählter weiterer elektrischer Hochspannungskomponenten der Prüfanordnung genutzt. Auf diese Weise sind die Prüfkomponenten während des Transportes der Prüfanordnung kompakt und ohne Berücksichtigung von Isolationsabständen innerhalb des quaderförmigen Behälters in der Transportposition anordenbar. Beim Aufbau des Prüfsystems vor Ort wird zunächst die Drossel aus dem Behälter bewegt. Danach wird der so entstandene Freiraum durch eine isolationsgerechte Anordnung von weiteren Hochspannungskomponenten genutzt, welche durch deren jeweilige Arbeitsposition bestimmt ist.

Es ist von Fall zu Fall selbstverständlich auch denkbar, dass der durch die herausbewegte Drossel freigewordene Raum nicht notwendigerweise durch eine Neuanordnung der weiteren Hochspannungskomponenten genutzt wird, sondern dass die weiteren Komponenten in Transportposition einen Freiraum im Inneren des Containers ermöglichen, welcher dann als Stauraum beispielsweise für ebenfalls benötigte Kleinkomponenten genutzt wird. Bei Aufbau der Prüfanordnung werden die Kleinkomponenten aus dem Stauraum entfernt und es erfolgt die isolationsgerechte Anordnung der weiteren Hochspannungskomponenten.

In vorteilhafter Weise wird durch die kompakte Anordnung der Drossel und der weiteren Hochspannungskomponenten innerhalb des Behälters ein Transport des Behälters bzw. der Prüfanordnung vereinfacht.

In bevorzugter Weise ist die wenigstens eine weitere Hochspannungskomponente ein elektrisches Filterelement. Derartige Filterelemente werden benötigt, um die von dem Wechselrichter erzeugte Wechselspannung zu glätten, d.h. den Anteil der ungewollten Oberschwingungen zu reduzieren, welche beispielsweise eine Teilentladungs- (TE-) Messung beeinflussen würden. Ein Filterelement weist in der Regel eine Induktivität und eine Kapazität auf, es sind jedoch auch Filterelementmodule mit nur einer Kapazität oder Induktivität denkbar. Es sind auch mehrere Filterelemente und/oder Filterelementmodule zu einem Filter verschaltbar. Bei derartigen Filterelementen ist ebenfalls auf einen hinreichenden Isolationsabstand zu anderen Hochspannungskomponenten zu achten.

In einer weiteren Variante der Prüfanordnung ist die wenigstens eine weitere Hochspannungskomponente ein Spannungswandler. Auch dieser ist eine Hochspannungskomponente, welche im Betrieb einen erhöhten Isolationsabstand benötigt.

In einer bevorzugten Ausgestaltungsvariante der erfindungsgemäßen Prüfanordnung ist die wenigstens eine weitere Hochspannungskomponente mittels einer Führungsvorrichtung bewegbar. Ein Bewegungsvorgang von der Transportposition in die Arbeitsposition ist hierdurch besonders vereinfacht.

In einer besonders bevorzugten Variante der Erfindung ist die wenigstens eine weitere Hochspannungskomponente längs einer Führungsschiene bewegbar. Dies ermöglicht ebenso wie die erfindungsgemäße Bewegung der wenigstens einen weiteren Hochspannungskomponente mittels einer Schwenkvorrichtung ein positionsgenaues und zugleich sicheres Bewegen zwischen Transport- und Arbeitsposition.

Entsprechend einer weiteren Umsetzungsvariante der erfindungsgemäßen Prüfanordnung ist die wenigstens eine weitere Hochspannungskomponente in der Transport- und/oder Arbeitsposition arretierbar. Dies erhöht die Sicherheit beim Transport und gewährleistet im Prüfbetrieb eine korrekte und betriebssichere Positionierung der Prüfkomponenten. Eine derartige Arretierung ist beispielsweise mittels einer schraubbaren Klemmverbindung oder einem Arretiermechanismus mit Schnappvorrichtung realisierbar.

Entsprechend einer weiteren Umsetzungsvariante der erfindungsgemäßen Prüfanordnung ist die wenigstens eine weitere Hochspannungskomponente im oberen Bereich des quaderförmigen Behälters angebracht und führbar, beispielsweise von der Decke hängend. Dies ermöglicht insbesondere, den Raum auf dem Boden des Behälters während des Transportes als Stauraum für benötigte Kleinteile vorzusehen, oder aber auch, auf dem Boden des Behälters weitere Hochspannungskomponenten stehend anzuordnen. Der im Behälter zur Verfügung stehende Platz wird hiermit in hohem Maße genutzt.

Entsprechend vorteilhaft ist es auch, die elektrischen Verbindungsleitungen zur wenigstens einen weiteren Hochspannungskomponente im oberen Bereich des quaderförmigen Behälters anzubringen. Diese Leitungen sind vorzugsweise so zu bemessen, dass die mit diesen verbundenen weiteren Hochspannungskomponenten sowohl in Transport- als auch in Arbeitsposition von den Leitungen ohne einen zusätzlichen Verbindungsvorgang erreicht sind. Dies ist beispielsweise mit einer Schlaufenführung einer flexiblen Leitung erreichbar. Durch das Führen der Leitungen im Deckenbereich ist zudem das Unfallrisiko für Bedienpersonal, welches sich beim Aufbau der Prüfanordnung vor Ort auf dem Behälterboden bewegt, reduziert.

Vorteilhafterweise sind die Verbindungsleitungen Kabel, welche von einer Isolationsschicht ummantelt sind. Bei der Anordnung von derart isolierten Kabeln innerhalb des quaderförmigen Behälters ist auf Isolationsabstände der Kabel zu geerdeten Gegenständen weitestgehend nicht zu achten, was die Anordnung weiter vereinfacht.

In einer bevorzugten Ausprägung der Prüfanordnung weist die Führungsvorrichtung für die wenigstens eine weitere Hochspannungskomponente einen Antrieb auf, beispielsweise einen Spindelantrieb mit Elektromotor oder einen hydraulischen Antrieb. Das Verfahren von der Transportposition in die Arbeitsposition und zurück wird dadurch weiter vereinfacht.

Der zur Verfügung stehende Platz im Behälter wird erfindungsgemäß besonders gut ausgenutzt, wenn sich die Arbeitsposition der wenigstens einen weiteren Hochspannungskomponente zumindest teilweise mit einem Bereich der nicht herausbewegten Drossel überschneidet.

In einer Ausgestaltungsform der Prüfanordnung ist ein Spannungsteiler zusammen mit der Hochspannungsdrossel aus dem quaderförmigen Behälter bewegbar. Durch das Herausbewegen auch eines Spannungsteilers aus dem Innenbereich des quaderförmigen Behälters wird in der Arbeitsposition noch mehr Platz im Behälter geschaffen, so dass die noch im Behälter verbleibenden Prüfkomponenten in einen nochmals erhöhten Isolationsabstand zueinander bewegbar sind.

Um einen sicheren Isolationsabstand zwischen der herausbewegten Hochspannungsdrossel und dem mit ihr herausbewegten Spannungsteiler herzustellen, ist erfindungsgemäß vorgesehen, den Spannungsteiler bei ausgefahrener Hochspannungsdrossel mit einer weiteren Bewegungsvorrichtung von der Hochspannungsdrossel weg in eine Isolationsposition zu bewegen. Vorzugsweise sind die Hochspannungsdrossel und der Spannungsteiler hierbei stets längs paralleler Achsen ausgerichtet.

Besonders bevorzugt ist in diesem Zusammenhang die Ausgestaltung des Behälters als Container mit Standardabmessung, beispielsweise als Container mit 40 Fuß Länge. Dieser ist in einer weiteren Variante gemäß CSC (Container Safety Convention) zugelassen und somit in jeder beliebigen Position innerhalb eines Containerstapels auf einem Containerschiff platzierbar. Hierdurch wird die Transportierbarkeit der Prüfanordnung noch weiter erhöht.

Vorteilhafterweise ist die wenigstens eine Öffnung des Behälters verschließbar. Bei einem Transport des Behälters mit geschlossenen Öffnungen sind die in ihm befindlichen Hochspannungskomponenten der Prüfanordnung somit besser geschützt.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: eine exemplarische Prüfanordnung in einer Seitenansicht,
- Fig. 2: eine exemplarische Prüfanordnung in einer Draufsicht und
- Fig. 3: eine exemplarische Prüfschaltung

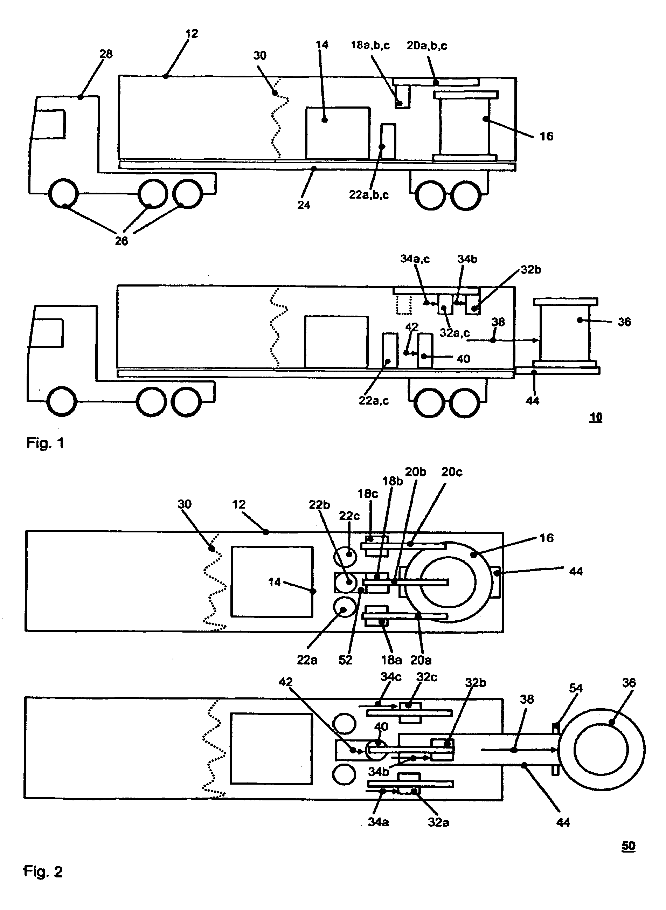

Fig. 1 zeigt eine exemplarische Prüfanordnung in einer Seitenansicht 10, im oberen Teil der Fig. in einer Transportposition und im unteren Teil der Fig. in einer Arbeitsposition. Ein quaderförmiger Behälter 12, ein Container mit Standardabmessungen, ist auf einem LKW-Auflieger 24 positioniert, welcher auf einem LKW 28, einem 3-achsigen Sattelschlepper, aufliegt. In dem Container 12 ist eine Prüfanordnung befindlich, von der jedoch nur ausgewählte Prüfkomponenten gezeigt sind. Neben einem ersten Prüftransformator 14, welcher fest in dem Container 12 montiert ist, sind insbesondere weitere bewegliche Prüfkomponenten gezeigt.

Eine erste Hochspannungsdrossel, welche auf einer Bewegungsvorrichtung 44 angeordnet ist, ist im oberen Bildteil in eingefahrenem Zustand in einer Transportposition 16 innerhalb der Begrenzungen des Containers 12 gezeigt. Von der Decke des Containers 12 hängend und an einer jeweiligen Führungsvorrichtung 20a, 20b und 20c montiert sind drei Filterelemente 18a, 18b und 18c in Transportposition angedeutet. Die Führungsvorrichtungen 20a, 20b und 20c sind in diesem Fall jeweils Hohlschienen, längs derer die jeweiligen Filterelemente über eine hakenähnliche Vorrichtung bewegbar sind, wobei in dieser Darstellung lediglich die erste Führungsvorrichtung 20a gezeigt ist, während die anderen beiden 20b und 20c verdeckt sind. Mittels einer nicht gezeigten Arretiervorrichtung sind die Filterelemente 18a, 18b und 18c zumindest in der oben gezeigten Transport- und in der unten gezeigten Arbeitsposition arretierbar. Der elektrische Anschluss der Filterelemente 18a, 18b und 18c erfolgt über nicht gezeigte isolierte Kabel von der Decke des Containers 12.

Es ist sowohl denkbar, dass die Filterelemente 18a, 18b und 18c permanent in beiden Positionen mit den jeweiligen Kabeln verbunden sind, es ist aber ebenso denkbar, dass die Kabelverbindung steckbar ist. Dies ist insbesondere dann von Vorteil, wenn die die Prüfanordnung an die örtlichen Gegebenheiten, die Frequenz der erzeugten Wechselspannung bzw. den Prüfling angepasst wird. Je nach Konstellation können auch nur ausgewählte Filterelemente, welche beispielsweise jeweils auf eine bestimmte Filterfrequenz angepasst sind, verschaltet werden.

Auf dem Boden des Containers 12 angedeutet sind drei Spannungswandler 22a, 22b, 22c in Transportposition, wobei hier aufgrund der Seitenansicht lediglich der erste Spannungswandler 22a sichtbar ist. Durch die vertikal gegenüberliegende Anordnung der von der Decke hängenden Filterelemente 18a, 18b und 18c sowie der auf dem Containerboden stehenden Spannungswandler 22a, 22b und 22c ist in der Transportposition der Prüfkomponenten der zur Verfügung stehende Innenraum des Containers 12 in hohem Maße ausgenutzt.

Im unteren Teil der Fig. 1 gezeigt ist dieselbe Prüfanordnung, wobei sich die Prüfkomponenten aber nunmehr in einer Arbeitsposition befinden. Die erste Hochspannungsdrossel ist nun in der Arbeitsposition 36 auf der ausgefahrenen Bewegungsvorrichtung 44 gezeigt, deren Bewegungsrichtung mit dem Pfeil 38 angedeutet ist. Ebenso sind alle drei von der Decke hängenden Filterelemente längs ihrer jeweiligen Führungsvorrichtung 20a, 20b und 20c in Richtung der Pfeile 34a, 34b und 34c in eine jeweilige Arbeitsposition 32a, 32b und 32c in einen hinteren Bereich im Container gerückt. Die elektrischen Isolationsabstände der Filterelemente in Arbeitsposition 32a, 32b und 32c und der nunmehr ebenfalls in Arbeitsposition 22a, 22c und 40 befindlichen Spannungswandler zueinander sind so groß, dass ein isolationstechnisch sicherer Betrieb der Prüfanordnung möglich ist.

Schematisch abgegrenzt zum bisher beschriebenen hinteren Bereich des Containers 12 ist der vordere Bereich des Containers 12 mit der Grenzlinie 30. Der vordere Bereich enthält weitere Komponenten wie beispielsweise Wechselrichter oder aber auch einen Arbeitsraum mit Mess- und Auswertevorrichtungen. Diese Komponenten sind aber in diesem Beispiel als gegenüber dem Container 12 unbeweglich anzunehmen, weshalb ihnen im Rahmen dieser Erfindung eine untergeordnete Bedeutung zukommt.

Fig. 2 zeigt eine vergleichbare exemplarische Prüfanordnung in einer Draufsicht 50. Mit Ausnahme des in dieser Fig. nicht gezeigten LKW ist die dargestellte Prüfanordnung mit den entsprechenden Prüfkomponenten auch bezüglich der verwendeten Bezugszeichen identisch. Eine zusätzlich dargestellte Komponente gegenüber Fig. 1 ist eine ausfahrbare Abstützung 54 unterhalb der ausgefahrenen Bewegungsvorrichtung 44 für die Hochspannungsdrossel in Arbeitsposition 36. Diese dient dem Zweck, die Verlagerung des Schwerpunktes des quaderförmigen Behälters 12, welche durch die herausgefahrene Hochspannungsdrossel entsteht, abzufangen und einen sicheren Stand der Prüfanordnung zu gewährleisten, insbesondere, wenn diese auch während der Prüfphase auf einem LKW-Auflieger verbleibt.

Eine weitere nunmehr sichtbare Komponente ist die Führungsvorrichtung 52 für den zweiten Spannungswandler, welcher in der oberen Darstellung in Transportposition 22b und in der unteren Darstellung in einer Arbeitsposition 40 dargestellt ist. Die Führungsvorrichtung ist in diesem Fall eine in den Boden des Containers eingelassene Führungsschiene, welche über einen Antrieb mittels Elektromotor und Kette verfügt. Die benachbarten Spannungswandler 22a und 22c sind fest montiert, verfügen also über keinerlei Führungsvorrichtungen.

In der Fig. 2 weiterhin sichtbar sind alle Filterelemente 18a, 18b und 18c in Transportposition bzw. mit den Bezugszeichen 32a, 32b und 32c dargestellt in Arbeitsposition sowie die zugehörigen Führungsvorrichtungen 20a, 20b und 20c. In der Fig. 1 waren diese Komponenten aufgrund der dargestellten Seitenansicht teilweise verdeckt und daher nicht sichtbar. Es ist in dieser Darstellung gut zu sehen, dass der Abstand der elektrischen Hochspannungskomponenten in der im oberen Bildteil gezeigten Darstellung sehr eng ist, so dass das zur Verfügung stehende Volumen des Containers 12 gut ausgenutzt ist. Im unteren Bildteil der Fig. hingegen sind die Hochspannungskomponenten in ihrer jeweiligen Arbeitsposition deutlich auseinandergerückt, so dass sich beim Betrieb der Prüfanordnung ein hinreichend hoher Isolationsabstand der Hochspannungskomponenten zueinander ergibt.

Selbstverständlich ist es möglich, die Führungsvorrichtungen 20a, 20b und 20c - abweichend zur Darstellung in Fig. 2 - auch in Querrichtung zur Längserstreckung des Containers anzuordnen, so dass diese in ihrer jeweiligen Transportposition an einer Seitenwand des Containers befindlich sind und bedarfsweise in ihre jeweilige Arbeitsposition in den mittleren Containerbereich bewegt werden. In dieser Variante sind die Filterelemente 18a, 18b und 18c in ihrer Transportposition in vorteilhafter Weise an einer Seitenwand des Containers beispielsweise mit Gurten fixierbar.

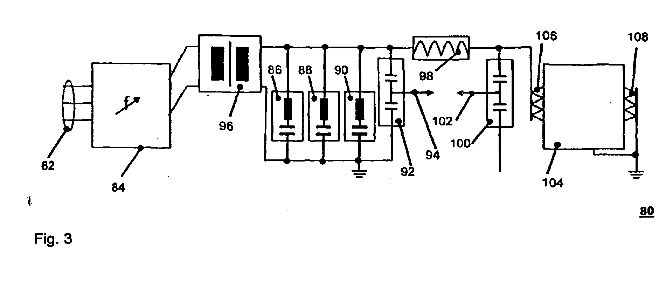

Fig. 3 zeigt ein elektrisches Übersichtsschaltbild 80 der Prüfschaltung, einen Resonanzschwingkreis, zu welchem ein Teil der Prüfkomponenten für Prüfungen mit besonders hohen Spannungen zusammenschaltbar ist. Ein derartiger Resonanzschwingkreis ist einphasig, d.h. bei denen in Fig. 1 teilweise 3-phasig angedeuteten Prüfkomponenten wird in dieser Anordnung jeweils nur eine Phase benutzt.

Ein Wechselrichter 84 ist über seine Eingänge 82 3-phasig mit einer Spannungsversorgung vor Ort verbunden, beispielsweise 400V, 50Hz. An den Ausgängen des Wechselrichters 84, welche mit den Anschlüssen der Unterspannungsseite eines zweiten Prüftransformators 96 verbunden sind, liegt während des Betriebes eine geregelte Wechselspannung an. Die transformierte Spannung an der Oberseite des zweiten Prüftransformators 96 wird mit den Filterelementen 86, 88, 90 geglättet. Die Anzahl von 3 Filterelementen ist hier nur schematisch dargestellt, selbstverständlich ist auch eine höhere Anzahl von Filterelementen denkbar. Die Filterelemente sind vorzugsweise für jeweils verschiedene Frequenzen ausgelegt, so dass durch Auswahl bzw. Verschaltung geeigneter Filterelemente auf die jeweiligen Randbedingungen der Hochspannungsprüfung eingegangen werden kann, wobei selbstverständlich vorhandene Filterelemente bedarfsweise ungenutzt sein können. Elektrisch parallel zu den Filterelementen 86, 88, 90 ist ein vierter Spannungswandler 92 geschaltet, welcher die vom Wechselrichter 84 erzeugte und vom zweiten Prüftransformators 96 transformierte Wechselspannung misst und über einen Spannungsabgriff 94 der nicht dargestellten Regelvorrichtung des Wechselrichters 84 zuführt.

Die Frequenz der Wechselspannung ist derart geregelt, dass der Resonanzschwingkreis in seiner Resonanzfrequenz angeregt wird. Der Resonanzschwingkreis weist in der Hauptsache eine zweite Hochspannungsdrossel 98, einen Prüfling 104 und einen kapazitiven fünften Spannungsteiler 100 auf. Die Hochspannungskomponenten sind derart aufeinander abgestimmt, dass sich eine Resonanzfrequenz von etwas über den üblichen 50Hz Netzfrequenz ergibt, beispielsweise 70Hz - 150Hz, wobei diese insbesondere von den Kenndaten des zu testenden Prüflings abhängt. Der Prüfling 104 ist in der dargestellten Fig. ein 3-phasiger Leistungstransformator, dessen unterspannungsseitigen Anschlüsse 108 jeweils mit einer Erdung verbunden sind und dessen oberspannungsseitigen Anschlüsse 106 elektrisch parallel zueinander im Schwingkreis verschaltet sind.

### Bezugszeichenliste

- 10: exemplarische Prüfanordnung in Seitenansicht
- 12: quaderförmiger Behälter
- 14: erster Prüftransformator
- 16: erste Hochspannungsdrossel in erster Position
- 18a: erstes Filterelement in Transportposition
- 18b: zweites Filterelement in Transportposition
- 18c: drittes Filterelement in Transportposition
- 20a: Führungsvorrichtung für erstes Filterelement
- 20b: Führungsvorrichtung für zweites Filterelement
- 20c: Führungsvorrichtung für drittes Filterelement
- 22a: erster Spannungswandler
- 22b: zweiter Spannungswandler in Transportposition
- 22c: dritter Spannungswandler (verdeckt)
- 24: LKW-Auflieger
- 25: Räder
- 28: LKW
- 30: Grenzlinie
- 32a: erstes Filterelement in Arbeitsposition
- 32b: zweites Filterelement in Arbeitsposition
- 32c: drittes Filterelement in Arbeitsposition
- 34a: Bewegungsrichtung des ersten Filterelementes
- 34b: Bewegungsrichtung des zweiten Filterelementes
- 34c: Bewegungsrichtung des dritten Filterelementes
- 36: erste Hochspannungsdrossel in zweiter Position
- 38: Bewegungsrichtung der ersten Hochspannungsdrossel
- 40: zweiter Spannungswandler in Arbeitsposition
- 42: Bewegungsrichtung des zweiten Spannungswandlers
- 44: Bewegungsvorrichtung für erste Hochspannungsdrossel
- 50: exemplarische Prüfanordnung in Draufsicht
- 52: Führungsvorrichtung für zweiten Spannungswandler
- 54: ausfahrbare Abstützung
- 80: exemplarische Prüfschaltung
- 82: 3-phasige Anschlussleitung
- 84: Wechselrichter
- 86: viertes Filterelement
- 88: fünftes Filterelement
- 90: sechstes Filterelement
- 92: vierter Spannungswandler
- 94: Spannungsabgriff von viertem Spannungswandler
- 96: zweiter Prüftransformator
- 98: zweite Hochspannungsdrossel
- 100: fünfter Spannungswandler
- 102: Spannungsabgriff von fünftem Spannungswandler
- 104: Prüfling
- 106: parallel geschaltete Eingänge des Prüflings
- 108: parallel geschaltete Ausgänge des Prüflings

## Patentansprüche

1. Prüfanordnung (10, 50) zur Wechselspannungsprüfung von elektrischen Hochspannungskomponenten (104), umfassend
• wenigstens einen Wechselrichter (84), wenigstens einen Prüftransformator (14, 96), wenigstens eine Hochspannungsdrossel (16, 36, 98) und wenigstens eine weitere Hochspannungskomponente (18a, 18b, 18c, 22a, 22b, 22c, 86, 88, 90, 92) als Prüfkomponenten,
• einen gemeinsamen quaderförmigen Behälter (12), in welchem wenigstens die genannten Prüfkomponenten angeordnet sind,
• eine Bewegungsvorrichtung (44),
• eine Führungsvorrichtung (20a, 20b, 20c, 52),
wobei die wenigstens eine Hochspannungsdrossel (16, 36, 98) mittels der Bewegungsvorrichtung (44) durch wenigstens eine Öffnung an einer Begrenzungsfläche des Behälters (12) zumindest teilweise aus diesem bewegbar ist und dadurch eine Wechsel zwischen einer ersten Anordnungsvariante der Hochspannungsdrossel innerhalb des quaderförmigen Behälters (12) und einer zweiten Anordnungsvariante mit einem genügendem Isolationsabstand zur Durchführung der Wechselspannungsprüfung ermöglicht ist und dass die wenigstens eine weitere Hochspannungskomponente (18a,18b, 18c, 22a, 22b, 22c, 86, 88, 90, 92) innerhalb des quaderförmigen Behälters (12) mittels der Führungsvorrichtung (20a, 20b, 20c, 52) von einer Transportposition (18a, 18b, 18c, 22b) in eine Arbeitsposition (32a, 32b, 32c, 64) bewegbar ist,
**dadurch gekennzeichnet, dass** die wenigstens eine weitere Hochspannungskomponente (18a, 18b, 18c, 22a, 22b, 22c, 86, 88, 90, 92) im oberen Bereich des quaderförmigen Behälters (12) angebracht und führbar ist.

2. Prüfanordnung nach Anspruch 1, **dadurch gekennzeichnet, dass** die wenigstens eine weitere Hochspannungskomponente (18a, 18b, 18c, 22a, 22b, 22c, 86, 88, 90, 92) ein elektrisches Filterelement (18a, 18b, 18c, 86, 88, 90) ist.

3. Prüfanordnung nach Anspruch 1 oder 2, **dadurch gekennzeichnet, dass** die wenigstens eine weitere Hochspannungskomponente (18a,18b, 18c, 22a, 22b, 22c, 86, 88, 90, 92) ein Spannungswandler ist (22a, 22b, 22c, 92).

4. Prüfanordnung nach einem der vorherigen Ansprüche, **dadurch gekennzeichnet, dass** die Führungsvorrichtung (20a, 20b, 20c, 52) eine Führungsschiene umfasst, längs derer die wenigstens eine weitere Hochspannungskomponente (18a, 18b, 18c, 22a, 22b, 22c, 86, 88, 90, 92) bewegbar ist.

5. Prüfanordnung nach einem der vorherigen Ansprüche, **dadurch gekennzeichnet, dass** die wenigstens eine weitere Hochspannungskomponente (18a, 18b, 18c, 22a, 22b, 22c, 86, 88, 90, 92) um eine Drehachse schwenkbar ist.

6. Prüfanordnung nach einem der vorherigen Ansprüche, **dadurch gekennzeichnet, dass** die wenigstens eine weitere Hochspannungskomponente (18a, 18b, 18c, 22a, 22b, 22c, 86, 88, 90, 92) in der Transport- (18a, 18b, 18c, 22b) und/oder Arbeitsposition (32a, 32b, 32c, 64) arretierbar ist.

7. Prüfanordnung nach einem der vorherigen Ansprüche, **dadurch gekennzeichnet, dass** elektrische Verbindungsleitungen zur wenigstens einen weiteren Hochspannungskomponente (18a, 18b, 18c, 22a, 22b, 22c, 86, 88, 90, 92) im oberen Bereich des quaderförmigen Behälters (12) angebracht sind.

8. Prüfanordnung nach Anspruch 7, **dadurch gekennzeichnet, dass** die Verbindungsleitungen Kabel sind, welche von einer Isolationsschicht ummantelt sind.

9. Prüfanordnung nach einem der vorherigen Ansprüche, **dadurch gekennzeichnet, dass** die Führungsvorrichtung (20a, 20b, 20c, 52) für die wenigstens eine weitere Hochspannungskomponente (18a, 18b, 18c, 22a, 22b, 22c, 86, 88, 90, 92) einen Antrieb aufweist.

10. Prüfanordnung nach einem der vorherigen Ansprüche, **dadurch gekennzeichnet, dass** sich die Arbeitsposition (32a, 32b, 32c, 64) der wenigstens einen weiteren Hochspannungskomponente (18a, 18b, 18c, 22a, 22b, 22c, 86, 88, 90, 92) zumindest teilweise mit einem Bereich der nicht herausbewegten Drossel (16) überschneidet.

11. Prüfanordnung nach einem der vorherigen Ansprüche, **dadurch gekennzeichnet, dass** ein Spannungsteiler (100) zusammen mit der Hochspannungsdrossel (16, 36, 98) aus dem quaderförmigen Behälter (12) bewegbar ist.

12. Prüfanordnung nach Anspruch 11, **dadurch gekennzeichnet, dass** der Spannungsteiler (100) relativ zur Hochspannungsdrossel (16, 36, 98) mit einer weiteren Bewegungsvorrichtung bewegbar ist.

13. Prüfanordnung nach einem der vorherigen Ansprüche, **dadurch gekennzeichnet, dass** der quaderförmige Behälter (12) ein transportierbarer Container mit Standardabmessungen ist.

14. Prüfanordnung nach einem der vorherigen Ansprüche, **dadurch gekennzeichnet, dass** die wenigstens eine Öffnung verschließbar ist.

## Claims

1. Test arrangement (10, 50) for AC voltage testing of electrical high-voltage components (104) comprising
• at least one inverter (84), at least one test transformer (14, 96), at least one high-voltage inductor (16, 36, 98) and at least one further high-voltage component (18a, 18b, 18c, 22a, 22b, 22c, 86, 88, 90, 92) as test components,
• a common cuboid container (12) in which at least said test components are arranged,
• a movement apparatus (44),
• a guide apparatus (20a, 20b, 20c, 52),
wherein the at least one high-voltage inductor (16, 36, 98) can be moved at least partially out of the container (12), through at least one opening on a boundary surface of the container (12), by means of the movement apparatus (44), and in this way a change is made possible between a first arrangement variant of the high-voltage inductor within the cuboid container (12) and a second arrangement variant with an adequate isolation separation for carrying out the AC voltage test, and in that the at least one further high-voltage component (18a, 18b, 18c, 22a, 22b, 22c, 86, 88, 90, 92) can be moved within the cuboid container (12) by means of the guide apparatus (20a, 20b, 20c, 52) from a transport position (18a, 18b, 18c, 22b) to a working position (32a, 32b, 32c, 64), **characterized in that** the at least one further high-voltage component (18a, 18b, 18c, 22a, 22b, 22c, 86, 88, 90, 92) is fitted and can be guided in the upper area of the cuboid container (12).

2. Test arrangement according to Claim 1, **characterized in that** the at least one further high-voltage component (18a, 18b, 18c, 22a, 22b, 22c, 86, 88, 90, 92) is an electrical filter element (18a, 18b, 18c, 86, 88, 90).

3. Test arrangement according to Claim 1 or 2, **characterized in that** the at least one further high-voltage component (18a, 18b, 18c, 22a, 22b, 22c, 86, 88, 90, 92) is a voltage transformer (22a, 22b, 22c, 92).

4. Test arrangement according to one of the preceding claims, **characterized in that** the guide apparatus (20a, 20b, 20c, 52) comprises a guide rail along which the at least one further high-voltage component (18a, 18b, 18c, 22a, 22b, 22c, 86, 88, 90, 92) can be moved.

5. Test arrangement according to one of the preceding claims, **characterized in that** the at least one further high-voltage component (18a, 18b, 18c, 22a, 22b, 22c, 86, 88, 90, 92) can be pivoted about a rotation axis.

6. Test arrangement according to one of the preceding claims, **characterized in that** the at least one further high-voltage component (18a, 18b, 18c, 22a, 22b, 22c, 86, 88, 90, 92) can be locked in the transport position (18a, 18b, 18c, 22b) and/or in the working position (32a, 32b, 32c, 64).

7. Test arrangement according to one of the preceding claims, **characterized in that** electrical connecting lines to the at least one further high-voltage component (18a, 18b, 18c, 22a, 22b, 22c, 86, 88, 90, 92) are fitted in the upper area of the cuboid container (12).

8. Test arrangement according to Claim 7, **characterized in that** the connecting lines are cables, which are sheathed by an insulation layer.

9. Test arrangement according to one of the preceding claims, **characterized in that** the guide apparatus (20a, 20b, 20c, 52) for the at least one further high-voltage component (18a, 18b, 18c, 22a, 22b, 22c, 86, 88, 90, 92) has a drive.

10. Test arrangement according to one of the preceding claims, **characterized in that** the working position (32a, 32b, 32c, 64) of the at least one further high-voltage component (18a, 18b, 18c, 22a, 22b, 22c, 86, 88, 90, 92) at least partially intersects an area of the inductor (16) which has not been moved out.

11. Test arrangement according to one of the preceding claims, **characterized in that** a voltage divider (100) can be moved, together with the high-voltage inductor (16, 36, 98), out of the cuboid container (12).

12. Test arrangement according to Claim 11, **characterized in that** the voltage divider (100) can be moved relative to the high-voltage inductor (16, 36, 98) by means of a further movement apparatus.

13. Test arrangement according to one of the preceding claims, **characterized in that** the cuboid container (12) is a transportable freight container with standard dimensions.

14. Test arrangement according to one of the preceding claims, **characterized in that** the at least one opening can be closed.

## Revendications

1. Arrangement de contrôle (10, 50) pour le contrôle de tension alternative de composants à haute tension (104) comprenant
• au moins un onduleur (84), au moins un transformateur de contrôle (14, 96), au moins une bobine à haute tension (16, 36, 98) et au moins un composant à haute tension supplémentaire (18a, 18b, 18c, 22a, 22b, 22c, 86, 88, 90, 92) en tant que composants de contrôle,
• un récipient (12) parallélépipédique commun dans lequel sont disposés au moins les composants de contrôle mentionnés,
• un dispositif de déplacement (44),
• un dispositif de guidage (20a, 20b, 20c, 52),
dans lequel l'au moins une bobine à haute tension (16, 36, 98) peut être déplacée au moyen du dispositif de déplacement (44) à travers au moins une ouverture sur une surface de délimitation du récipient (12) de manière à sortir au moins partiellement hors de celui-ci et il est ainsi possible de réaliser une alternance entre une première variante d'arrangement de la bobine à haute tension à l'intérieur du récipient (12) parallélépipédique et une deuxième variante d'arrangement avec une distance d'isolation suffisante pour effectuer le contrôle de tension alternative et en ce que l'au moins un composant à haute tension supplémentaire (18a, 18b, 18c, 22a, 22b, 22c, 86, 88, 90, 92) peut être déplacé à l'intérieur du récipient (12) parallélépipédique au moyen du dispositif de guidage (20a, 20b, 20c, 52) d'une position de transport (18a, 18b, 18c, 22b) en une position de travail (32a, 32b, 32c, 64), **caractérisé en ce que** l'au moins un composant à haute tension supplémentaire (18a, 18b, 18c, 22a, 22b, 22c, 86, 88, 90, 92) est amené et peut être guidé dans la zone supérieure du récipient (12) parallélépipédique.

2. Arrangement de contrôle selon la revendication 1, **caractérisé en ce que** l'au moins un composant à haute tension supplémentaire (18a, 18b, 18c, 22a, 22b, 22c, 86, 88, 90, 92) est un élément filtrant électrique (18a, 18b, 18c, 86, 88, 90).

3. Arrangement de contrôle selon la revendication 1 ou 2, **caractérisé en ce que** l'au moins un composant à haute tension supplémentaire (18a, 18b, 18c, 22a, 22b, 22c, 86, 88, 90, 92) est un convertisseur de tension (22a, 22b, 22c, 92).

4. Arrangement de contrôle selon l'une des revendications précédentes, **caractérisé en ce que** le dispositif de guidage (20a, 20b, 20c, 52) comprend un rail de guidage le long duquel l'au moins un composant à haute tension supplémentaire (18a, 18b, 18c, 22a, 22b, 22c, 86, 88, 90, 92) peut être déplacé.

5. Arrangement de contrôle selon l'une des revendications précédentes, **caractérisé en ce que** l'au moins un composant à haute tension supplémentaire (18a, 18b, 18c, 22a, 22b, 22c, 86, 88, 90, 92) peut pivoter autour d'un axe de rotation.

6. Arrangement de contrôle selon l'une des revendications précédentes, **caractérisé en ce que** l'au moins un composant à haute tension supplémentaire (18a, 18b, 18c, 22a, 22b, 22c, 86, 88, 90, 92) peut être bloqué en position de transport (18a, 18b, 18c, 22b) et/ou en position de travail (32a, 32b, 32c, 64).

7. Arrangement de contrôle selon l'une des revendications précédentes, **caractérisé en ce que** des lignes de liaison électrique vers au moins un composant à haute tension supplémentaire (18a, 18b, 18c, 22a, 22b, 22c, 86, 88, 90, 92) sont posées dans la zone supérieure du récipient (12) parallélépipédique.

8. Arrangement de contrôle selon la revendication 7, **caractérisé en ce que** les lignes de liaison sont des câbles qui sont gainés par une couche isolante.

9. Arrangement de contrôle selon l'une des revendications précédentes, **caractérisé en ce que** le dispositif de guidage (20a, 20b, 20c, 52) comprend un mécanisme d'entraînement pour l'au moins un composant à haute tension supplémentaire (18a, 18b, 18c, 22a, 22b, 22c, 86, 88, 90, 92).

10. Arrangement de contrôle selon l'une des revendications précédentes, **caractérisé en ce que** la position de travail (32a, 32b, 32c, 64) de l'au moins un composant à haute tension supplémentaire (18a, 18b, 18c, 22a, 22b, 22c, 86, 88, 90, 92) chevauche au moins partiellement une zone de la bobine (16) qui n'est pas déplacée à l'extérieur.

11. Arrangement de contrôle selon l'une des revendications précédentes, **caractérisé en ce qu'**un diviseur de tension (100) peut être déplacé hors du récipient (12) parallélépipédique conjointement avec la bobine à haute tension (16, 36, 98).

12. Arrangement de contrôle selon la revendication 11, **caractérisé en ce que** le diviseur de tension (100) peut être déplacé par rapport à la bobine à haute tension (16, 36, 98) avec un dispositif de déplacement supplémentaire.

13. Arrangement de contrôle selon l'une des revendications précédentes, **caractérisé en ce que** le récipient (11) parallélépipédique est un conteneur transportable ayant des dimensions standard.

14. Arrangement de contrôle selon l'une des revendications précédentes, **caractérisé en ce que** l'au moins une ouverture peut être fermée.
